## Europäisches Patentamt

## European Patent Office

## Office européen des brevets

(19)

(11) Veröffentlichungsnummer: **0 234 384**

**A1**

# EUROPÄISCHE PATENTANMELDUNG

(21) Anmeldenummer: **87101759.6**

(22) Anmeldetag: **09.02.87**

(51) Int. Cl.⁴: **H01L 27/10** , H01L 21/20 , //G11C11/34

(30) Priorität: **12.02.86 DE 3604362**

(43) Veröffentlichungstag der Anmeldung: **02.09.87 Patentblatt 87/36**

(84) Benannte Vertragsstaaten: **AT DE FR GB IT NL**

(71) Anmelder: **Siemens Aktiengesellschaft Berlin und München**
**Wittelsbacherplatz 2**
**D-8000 München 2(DE)**

(72) Erfinder: **Kohl, Michael, Dipl.-Ing.**
**Hauzenberger Strasse 20**
**D-8000 München 21(DE)**

(54) **Dreidimensionale 1-Transistorzellenanordnung für dynamische Halbleiterspeicher und Verfahren zu ihrer Herstellung.**

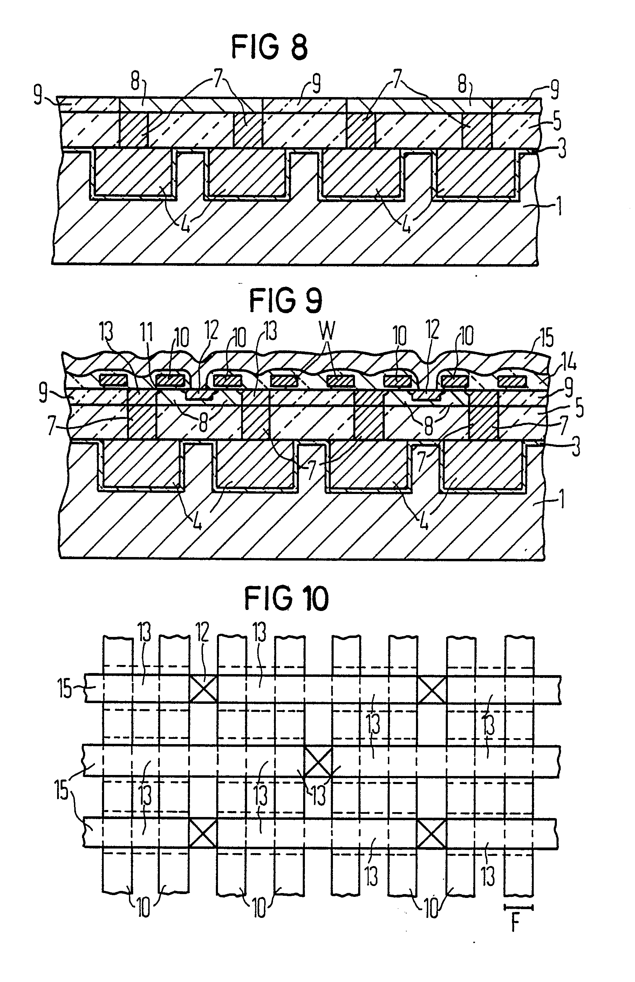

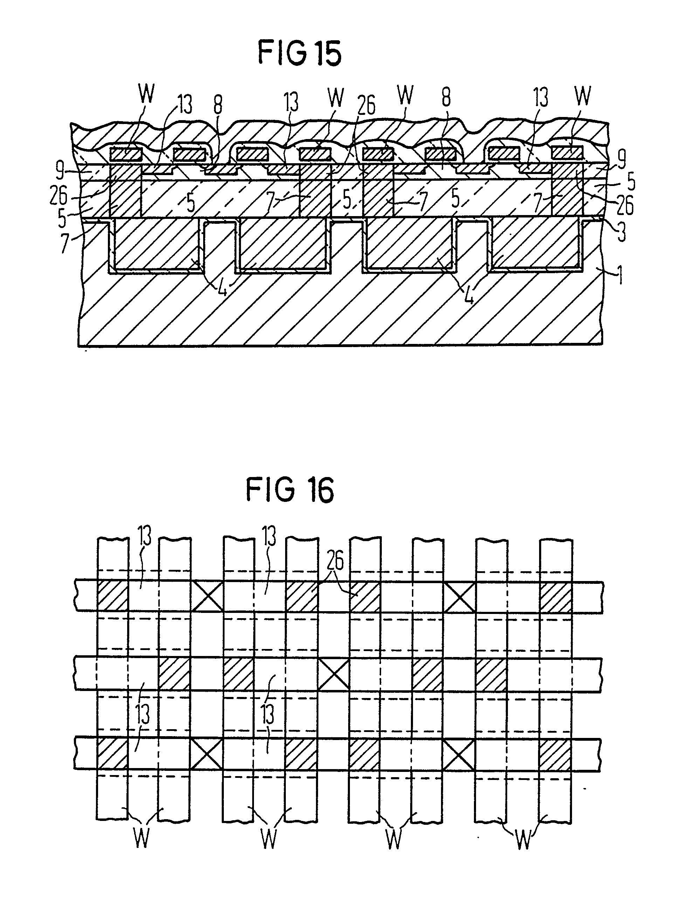

(57) Die erfindungsgemäße dreidimensionale 1-Transistorzellenanordnung, bei der der Kondensator für die zu speichernden Ladungen als Plattenkondensator unterhalb des Feldeffekttransistors angeordnet ist, ist auf einem Substrat (1) aufgebaut, welches zumindest in den an den Speicherkondensator (3, 4) angrenzenden Bereich aus Metall besteht oder in diesem Bereich metallisch leitende Eigenschaften aufweist, so daß das Substrat (1) selbst auch als Speicherplatte dient. Zwischen Speicherkondensator (1, 3, 4) und Feldeffekttransistoren (8,9, 10, 11, 12) befindet sich eine Zwischenisolatorschicht (5), die durch elektrisch leitende Bereiche (7) unterbrochen ist. Die Anordnung kann sowohl als Grabenzelle - (Figur 9, Figur 15), als auch mit planarem Aufbau - (Figur 14) dimensioniert sein. Durch die Erfindung können Zellkonzepte für dynamische Halbleiterspeicher mit einer Kapazität von 64 M und darüber mit geringer Fehlerwahrscheinlichkeit und geringem Soft-Error durch ionisierende Strahlung in einfachen, technisch beherrschbaren Verfahrensschritten realisiert werden.

FIG 9

EP 0 234 384 A1

## Dreidimensionale 1-Transistorzellenanordnung für dynamische Halbleiterspeicher und Verfahren zu ihrer Herstellung.

Die Erfindung betrifft eine dreidimensionale 1-Transistorzellenanordnung für dynamische Halbleiterspeicher, bei der der Kondensator für die zu speichernden Ladungen als Plattenkondensator ausgebildet ist und unterhalb des an der Oberfläche des gemeinsamen Substrates liegenden Feldeffekt-Transistors mit isolierter Gate-Elektrode angeordnet ist und mit dessen Source-oder Drainzone elektrisch leitend verbunden ist, sowie Verfahren zu ihrer Herstellung.

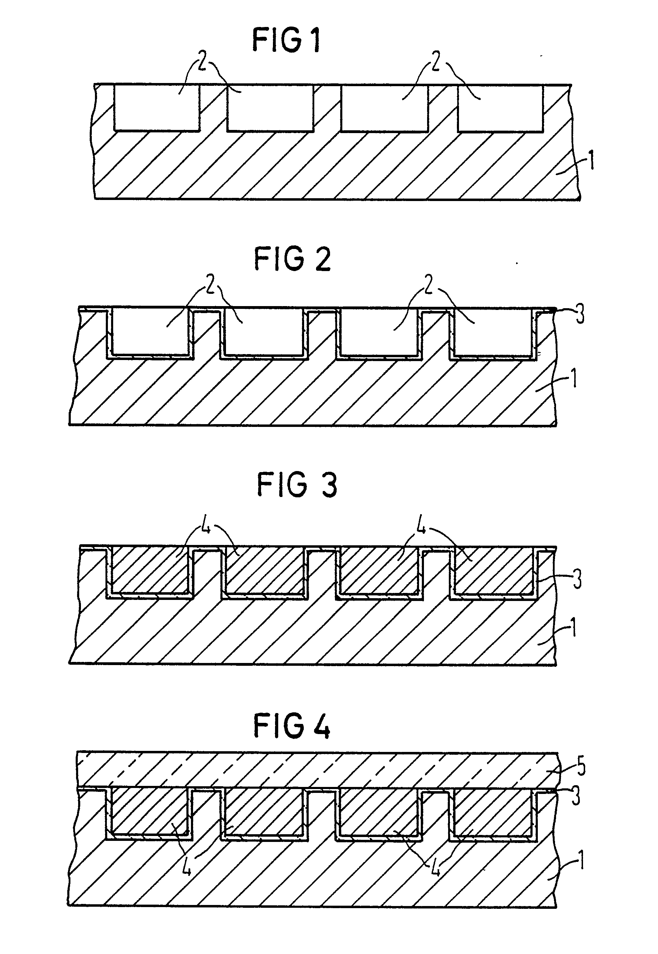

Eine solche Anordnung ist beispielsweise aus einem Bericht von Sunami et. al. aus dem IEEE 1983, Electron Device Letters Vol. EDL-4, Nr. 4, Seiten 90/91 (Figur 1), bekannt.

Die zunehmende Verkleinerung in integrierten Schaltungen benötigt neue Techniken für die Unterbringung der Bauelementstrukturen. Für dynamische Halbleiterspeicher mit einer Kapazität von 64 M und darüber werden hochdichte Zellkonzepte mit einer Zellfläche von kleiner 2 $\mu$m² benötigt. Bei der heute verwendeten 1-Transistorzelle wird die minimale Zellfläche im wesentlichen bestimmt durch die zu speichernde Mindestladung. Aufgrund der Soft-Error (= Speicherfehler) durch Alphateilchen ist dabei von minimal 150 fC (femto Coulomb = $10^{-15}$ C) auszugehen.

Um ein solches Ladungspaket speichern zu können, ist bereits ab dem Speicher mit einer Kapazität von 4 M eine quasi dreidimensional integrierte Anordnung von Transistor und Kondensator erforderlich. Unter dreidimensionaler Integration versteht man die Übereinanderanordnung von mindestens zwei aktiven Bauelementschichten. Dies führt zu einem Gewinn in der Chipfläche von mindestens einem Faktor 2.

Eine dreidimensionale Struktur von Kondensator und Transistor ist zum Beispiel aus einem Bericht von Sturm, Giles und Gibbons aus IEEE Electron Device Letters, Vol. EDL-5, Nr. 5 (1984), Seiten 151 bis 153, bekannt. Bei diesem, auch als folded capacitor-Struktur bezeichneten Aufbau liegt der als Plattenkondensator aufgebaute aus dotiertem Polysilizium bestehende Speicherkondensator unter dem Transistor. In einer dritten Polysiliziumebene wird der Transistor erzeugt.

Um die Kondensatorfläche ohne zusätzlichen Platzbedarf zu vergrößern, wird in einer Veröffentlichung von P. Morie et. al. im IEEE Electron Device Letters, Vol. EDL-4, Nr. 11, November 1983, auf den Seiten 411 bis 414 ein Grabenzellenkonzept vorgeschlagen, bei dem der Kondensator als Graben in einem Halbleitersubstrat aus p-dotiertem Silizium, ähnlich wie in der eingangs genannten Literaturstelle von Sunami, eingebracht ist.

Während bei der Anordnung nach Sunami der Transistor an der Oberfläche des gemeinsamen, ebenfalls aus Silizium bestehenden Substrats, aber neben dem Grabenzellenkondensator angeordnet ist (Figur 1), wird in dem Bericht von Morie nur die Herstellung der Zelle selbst beschrieben. Unter anderem wird als Isolatorschicht für den Speicherkondensator Siliziumdioxid, Siliziumnitrid oder Doppel- und Dreifachschichten davon vorgeschlagen.

Auch mit den besten, für höchstintegrierte Schaltungen geeigneten Dielektrika ist es unmöglich, mit einer pla nar übereinander aufgebauten Speicherzelle Zellflächen von 2 $\mu$m² zu erreichen. Das Konzept der Grabenzelle (trench capacitor oder corrugated capacitor), wie es aus den Veröffentlichungen von Sunami und Morie zu entnehmen ist, läßt dies zwar prinzipiell zu, die dann aber benötigte Grabentiefe (größer 10 $\mu$m) und Aspektverhältnisse geben technologisch unlösbare Probleme auf.

Der Erfindung liegt deshalb die Aufgabe zugrunde, unter Verwendung der dreidimensionalen Integration der Bauelemente eine 1-Transistorzellenanordnung für dynamische Halbleiterspeicher zu - schaffen, bei der der Kondensator vollständig unter dem Transistor angeordnet ist, so daß die gesamte Zellfläche für den Kondensator benutzt wird. Neben der Erzielung einer höchsten Integration bei möglichst kleiner Chipfläche mit möglichst großen Strukturen sollen eine geringe Fehlerwahrscheinlichkeit beim Betrieb, eine hohe Lebensdauer und geringer Soft-Error durch ionisierende Strahlung gegeben sein.

Eine weitere Aufgabe ist, diese Zellen in integrierten Schaltungen mit möglichst einfachen, technisch beherrschbaren Verfahrensschritten zu realisieren.

Zur Lösung der erfindungsgemäßen Aufgabe wird eine dreidimensionale 1-Transistorzelle der eingangs genannten Art vorgeschlagen, die dadurch gekennzeichnet ist, daß

a) das Substrat zumindest in dem an den Speicherkondensator angrenzenden Bereich aus Metall besteht oder in diesem Bereich metallisch leitende Eigenschaften aufweist, so daß das Substrat selbst oder die in dem Substrat enthaltene metallisch leitende Schicht auch als Speicherplatte dient, und

b) eine Zwischenisolatorschicht im Substrat zwischen Speicherkondensator und Feldeffekt-Transistor angeordnet ist, die durch elektrisch leitende Bereiche unterbrochen ist.

Dabei liegt es im Rahmen der Erfindung, daß der Kondensator als Graben-Kondensator im Metallsubstrat oder im metallisch leitenden Teil des Substrates ausgebildet ist. Der Aufbau der Transistorzelle kann aber auch so gewählt werden, daß der Kondensator planar auf dem aus Metall bestehenden Substrat oder auf der Oberfläche der metallisch leitenden Schicht angeordnet ist.

Bei dem erfindungsgemäßen Zellkonzept, bei dem von einem Metallsubstrat oder einer, auf einem Substrat aufgebrachten metallisch leitenden Schicht ausgegangen wird, in das bzw. in die dann zum Beispiel Gräben eingebracht werden und bei dem das Substrat oder die metallisch leitende Schicht später als Speicherplatte verwendet wird, können -im Gegensatz zur Verwendung eines Siliziumsubstrates -keine von Alpha-Teilchen oder kosmischer Strahlung generierte Ladungsträger auftreten, die zu Soft-Error führen können. Damit kann die zu speichernde Ladung bei den heutigen Leseverstärkerempfindlichkeiten weiter auf ca. 100 fC verkleinert werden.

Wesentlich ist aber auch, daß durch das erfindungsgemäße Zellkonzept, bei dem der Kondensator direkt unter dem Transistor angeordnet ist, der Kondensator die ganze Zellfläche benutzen kann und dadurch die Grabentiefe geringer sein kann als bei den bekannten Anordnungen und damit besser technisch beherrschbar ist. Bei allen bekannten Zellkonzepten wird der Platzbedarf durch Kondensator und Transistor bestimmt, wodurch fast immer ein Drittel der Fläche verlorengeht.

Unter Verwendung selbstjustierender Techniken ist bei der Erfindung eine Zellfläche von 10 Lithographiequadraten erzielbar. Die Zelle ist skalierbar, soweit es die Aspektverhältnisse des Grabens zulassen. Würde für einen 64 M-Speicher eine Zellfläche von 2 $\mu m^2$ (Chipfläche 200 $mm^2$) angestrebt, so würde im Zellenfeld eine minimale Strukturgröße von 0,45 $\mu m$ benötigt, die durch Elektronenstrahl-oder Röntgenstrahl-Belichtung realisierbar ist. Folgende Bedingungen wurden dieser Berechnung zugrundegelegt: 100 fC bei $V_{DD}$ = 2,5 V (Betriebsspannung) ergibt Plattenspannung $V_P$ = 1,25 V (= $V_{DD}/2$), Tiefe des Grabens 0,7 $\mu m$ bei einer Öffnung .von 1,35 $\mu m$ x 0,67 $\mu m$ mit Siliziumnitrid als Isolatorschicht mit einer Schichtdicke von 10 nm.

Ein weiterer Aspekt ist, daß durch die Verwendung des Metallsubstrates kein teueres, einkristallines Silizium mehr erforderlich ist. Es können rechteckige Scheiben verwendet werden, wodurch der Ausbeuteverlust am Rand von runden Siliziumkristallscheiben vermieden wird. Insbesondere ist dies wichtig bei großen Chipflächen (64 M ungefähr 200 $mm^2$).

Weitere Ausgestaltungen der Erfindung, insbesondere Verfahren zu ihrer Realisierung, ergeben sich aus den Unteransprüchen.

Im folgenden werden anhand von Ausführungsbeispielen und der Figuren 1 bis 16 verschiedene Verfahren zur Herstellung der erfindungsgemäßen Anordnungen noch näher erläutert.

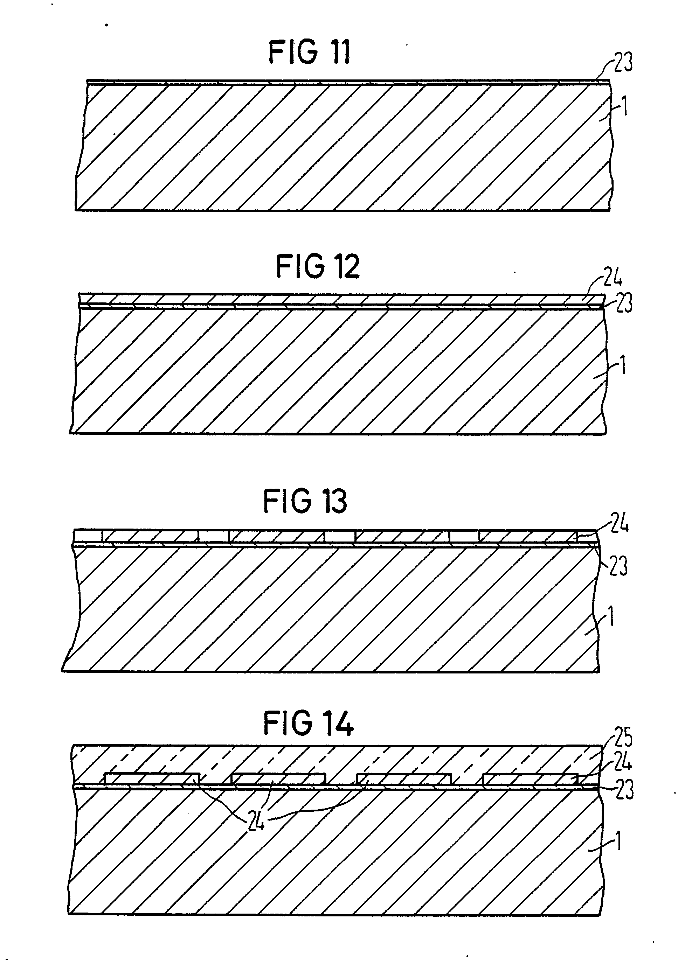

Dabei zeigen die Figuren 1 bis 9 und 11 bis 15 im Schnittbild die erfindungswesentlichen Verfahrensschritte, wobei sich die Figuren 1 bis 9 auf eine Ausführungsform mit Grabenkondensator und die Figuren 11 bis 14 auf einen planaren Aufbau des Speicherkondensators beziehen. Die Figur 15 betrifft eine spezielle Ausführungsform der Figur 9. Die Figuren 10 und 16 zeigen Layouts der Figuren 9 und 15.

Figur 1: In ein zum Beispiel aus Wolfram bestehendes Metallsubstrat 1 werden entsprechend der Größe der Speicherkondensatoren Gräben 2 unter Verwendung bekannter Verfahrensschritte des reaktiven Ionenätzens eingebracht. Anstelle des ganz aus Metall bestehenden Substrates 1 kann auch nur ein Schichtteil 1 an der Oberfläche des Substrates aus Metall bestehen, während das übrige Substrat aus Silizium besteht (nicht abgebildet). Beide Teile des Substrates (Metall und Silizium) können durch eine Isolationsschicht voneinander getrennt sein. Der Substratteil 1 kann auch aus einer bis zur metallischen Leitfähigkeit dotierten Siliziumschicht bestehen.

Figur 2: Durch Abscheiden von $SiO_2$, Siliziumnitrid oder Doppel-und Dreifach-Schichten von zum Beispiel $SiO_2$-Siliziumnitrid-$SiO_2$, von Tantalpentoxid oder durch einfache Oxidation des aus Wolfram bestehenden, mit den Gräben 2 versehenen Substrates 1 wird die Isolatorschicht 3 für den Speicherkondensator gebildet. Im Ausführungsbeispiel ist dies eine zum Beispiel 10 nm dicke Wolframoxidschicht.

Figur 3: Durch Abscheidung aus der Gasphase (CVD = chemical vapor depositon) werden dann die mit der Wolframoxidschicht 3 versehenen Gräben 2 mit dotiertem polykristallinem Silizium 4 vollständig aufgefüllt und eventuell auf der Oberfläche des Substrats 1, 2, 3 abgeschiedenes Silizium durch Rückätzen enfernt. Anstelle von dotiertem polykristallinem Silizium können auch Refractory-Metalle (Wolfram, Titan, Molybdän, Tantal, Niob) oder deren Silizide verwendet werden.

Figur 4: Auf die nun plane Oberfläche des Substrates (1, 3, 4) wird anschließend die zwischen Speicherkondensator (1, 3, 4) und Feldeffekttransistoren angeordnete Zwischenisolatorschicht 5, zum Beispiel aus $SiO_2$ bestehend, in einer Schichtdicke im Bereich von 0,5 bis 1 $\mu m$ aufgebracht.

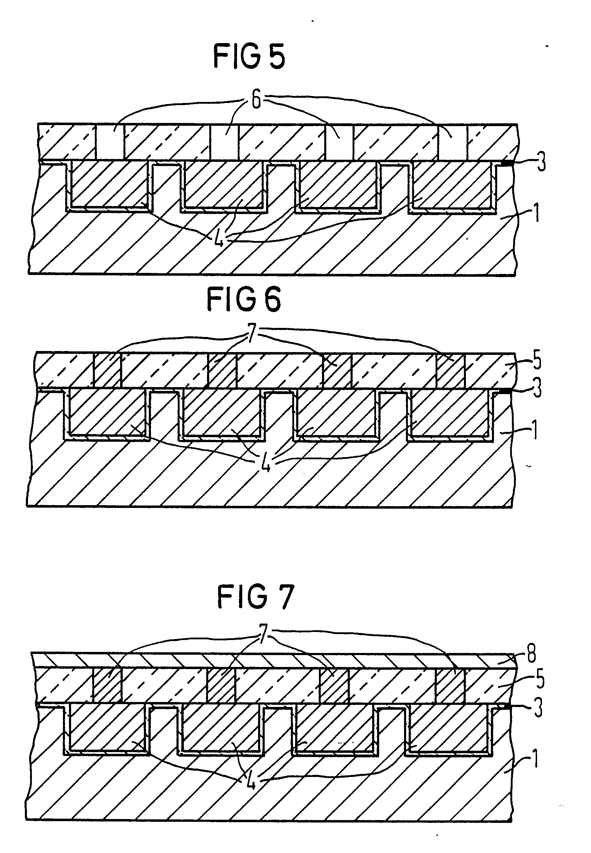

Figur 5: In die Zwischenisolatorschicht 5 werden nun, ebenfalls durch reaktives Ionenätzen wie bei der Erzeugung der Gräben 2 im Substrat 1 bei Figur 1 beschrieben, Kontaktlöcher 6 für die elektrisch leitenden Bereiche (7) zu den Kondensatoren eingebracht.

Figur 6: Die elektrisch leitenden Bereiche 7 werden durch die Auffüllung der Kontaktlöcher 6 hergestellt; zum Beispiel durch selektive Abscheidung von Wolfram.

Figur 7: Auf die planare Anordnung (1, 3, 4, 5, 7) wird nun die, die Transistoren enthaltende Halbleiterschicht 8 aufgebracht, welche entweder aus einer durch ganzflächige Abscheidung aus der Gasphase erzeugten polykristallinem Siliziumschicht 8 oder auch aus einer amorphen Siliziumschicht 8 bestehen kann. Diese Schicht 8 wird im Anschluß an ihre Entstehung und ihre, je nach Kanaltyp vorgenommenen Dotierung in den einkristallinen Zustand übergeführt. Dies geschieht beispielsweise durch Kristallisation mit dem Laser (Ar, $CO_2$), mit einem Elektronenstrahl, einem Graphitheizer oder einer Lampe.

Figur 8: In bekannter Weise (LOCOS-, Box- oder Grabenisolationstechnik) werden in der einkristallinen Siliziumschicht 8 Feldisolationsbereiche 9 erzeugt. Dies kann zum Beispiel auch durch selektive Durchoxidation der Schicht 8 erfolgen.

Figur 9: In den noch einkristallinen Bereichen 8 werden dann nach erfolgter Gateoxidation und Herstellung der Gate-Elektroden 10 - (Wortleitung W) durch Einbringen von Dotierstoffionen, zum Beispiel durch Ionen-Implantation, - schwach dotierte Drain-Zonen 11 der Transistoren in bekannter Weise erzeugt. Nach der Durchführung einer konformen $SiO_2$-Abscheidung und Rückätzung zur Bildung von Flankenoxiden an den Gate-Elektroden 10 (ist im einzelnen in der Figur nicht dargestellt) werden die Source/ Drain-Zonen 11 in zum Beispiel zwei Schritten erzeugt, wobei im ersten Schritt eine flache Ionen-Implantation (12) und im zweiten Schritt nach Maskierung der für den späteren Bitleitungsanschluß vorgesehenen Bereich 12 eine tiefe Implantation zur Herstellung der leitenden Verbindung 13 zwischen dem nicht maskierten Gebiet und dem Kondensator (7) durchgeführt wird. Abschließend wird ganzflächig eine als Zwischenoxid dienende $SiO_2$-Schicht 14 aufgebracht und mit Kontaktlöchern zu den für die Bitleitung (15) vorgesehenen Bereichen 12 versehen. Die für die Bitleitung 15 vorgesehene Metallisierung besteht beispielsweise aus Aluminium.

Figur 10 zeigt ein Zellenfeld gemäß Figur 9 im Layout. Dabei gelten die gleichen Bezugszeichen wie in Figur 9. Die mit X versehenen Bereiche sind die Bitleitungskontakte für je zwei Zellen. Die Zellfläche beträgt 4 F x 2,5 F, wobei F = Feature Size = Strukturgröße. Wie aus der Figur 10 ersichtlich ist, liegt eine gefaltete Bitleitung vor.

Damit kann bei einer Strukturgröße von F = 0,45 μm eine Zellfläche von 2 μm² erzielt werden, bei F = 0,3 μm eine Zellfläche von 0,9 μm².

Figur 11: Zur Erzeugung eines planaren Kondensators wird ebenfalls von einem Metallsubstrat 1 oder einer auf einem Substrat aus zum Beispiel oxidiertem Silizium aufgebrachten Metallschicht 1 ausgegangen, die zum Beispiel aus Tantal besteht. Das mit der Tantaloberfläche versehene Substrat 1 wird ganzflächig oxidiert, wobei die aus Tantalpentoxid bestehende Isolatorschicht 23 gebildet wird.

Figur 12: Das mit der Oxidschicht 23 versehene Metallsubstrat 1 wird nun ganzflächig mit einer aus zum Beispiel dotiertem Polysilizium bestehenden Schicht 24 versehen (Schichtdicke 0,3 μm). Anstelle von dotiertem Polysilizium kann auch, wie bei Figur 3 beschrieben, ein Refractory-Metall, wie Tantal oder dessen Silizid ver wendet werden.

Figur 13: Die Schicht 24 wird entsprechend der Flächengröße des Speicherkondensators strukturiert.

Figur 14: Auf diesen planaren Kondensatoraufbau (1, 23, 24) wird nun genau wird bei Figur 4 beschrieben, die Zwischenisolatorschicht 25 aufgebracht, die in diesem Falle wegen ihrer einebnenden Wirkung aus Bor-Phosphor-Silikatglas bestehen kann. Darauf wird nach Einätzen der Kontaktlöcher (6) für die elektrisch leitenden Bereiche (7) zu den Kondensatoren (Figur 5 und 6) die für die Transistoren erforderliche Halbleiterschicht (8, Figur 7) aufgebracht. Die weitere Verfahrensfolge ist bekannt, bzw. aus der Beschreibung zur Figur 9 zu entnehmen.

Figur 15 zeigt eine spezielle Ausführungsform einer Grabenkondensatorzelle nach der Lehre der Erfindung entsprechend Figur 9. Diese Ausführungsform, die sich von der in den Figuren 1 bis 10 beschriebenen Zelle durch die Kontakttrennung zum Kondensator unterscheidet, wird abweichend von Figur 1 bis 9 dadurch hergestellt, daß nach dem Herstellen der Feldisolationsbereiche (9 in Figur 8) Dotierstoffe vom entgegengesetzten Leitungstyp wie die einkristalline Siliziumschicht (8) in die Bereiche 26 dieser Schicht (8) eingebracht werden, die die oberhalb des aus der leitenden Verbindung (7) gebildeten Kontaktes und der später erzeugten Wortleitung W der benachbarten Speicherzelle liegen. Wie aus der Figur 15 zu ersehen ist, können dadurch die Eigenschaften der S/D-Gebiete 13 unabhängig von der Durchkontaktierung eingestellt werden.

Figur 16: Die mit X gekennzeichneten Bereiche zeigen in gefalteter Anordnung die Bitleitungskontakte für die zwei Zellen. Die mit einer Schraffur versehenen Bereiche des Zellenfeldes entsprechen den Kontakten für die Wortleitung W.

**Ansprüche**

1. Dreidimensionale 1-Transistorzellenanordnung für dynamische Halbleiterspeicher, bei der der Kondensator für die zu speichernden Ladungen als Plattenkondensator ausgebildet ist und unterhalb des an der Oberfläche des gemeinsamen Substrates liegenden Feldeffekt-Transistors mit isolierter Gate-Elektrode angeordnet ist und mit dessen Source-oder Drainzone elektrisch leitend verbunden ist, **dadurch gekennzeichnet, daß**

a) das Substrat (1) zumindest in dem an den Speicherkondensator (3, 4) angrenzenden Bereich aus Metall besteht oder in diesem Bereich metallisch leitende Eigenschaften aufweist, so daß das Substrat (1) selbst oder die in dem Substrat enthaltene metallisch leitende Schicht (1) auch als Speicherplatte dient, und

b) eine Zwischenisolatorschicht (5) im Substrat zwischen Speicherkondensator (1, 3, 4) und Feldeffekt-Transistor (8, 9, 10, 11, 12) angeordnet ist, die durch elektrisch leitende Bereiche (7) unterbrochen ist.

2. Dreidimensionale 1-Transistorzellenanordnung nach Anspruch 1, **dadurch gekennzeichnet,** daß der Kondensator als Graben-Kondensator (3, 4) im Metallsubstrat (1) oder im metallisch leitenden Teil (1) des Substrates ausgebildet ist (Figur 4).

3. Dreidimensionale 1-Transistorzellenanordnung nach Anspruch 1, **dadurch gekennzeichnet,** daß der Kondensator (23, 24) planar auf dem aus Metall bestehenden Substrat (1) oder auf der Oberfläche der metallisch leitenden Schicht (1) aufgebaut ist (Figur 14).

4. Dreidimensionale 1-Transistorzellenanordnung nach einem der Ansprüche 1 bis 3, **dadurch gekennzeichnet,** daß das Substrat (1) oder die metallisch leitende Schicht (1) aus einem insbesondere hochschmelzenden Metall wie Wolfram, Molybdän, Titan, Tantal oder deren Silizide besteht.

5. Dreidimensionale 1-Transistorzellenanordnung nach einem der Ansprüche 1 bis 3, **dadurch gekennzeichnet,** daß das Substrat (1) aus einer bis an die metallische Leitfähigkeit hochdotierten Siliziumkristallscheibe besteht.

6. Dreidimensionale 1-Transistorzellenanordnung nach einem der Ansprüche 1 bis 3, **dadurch gekennzeichnet,** daß das Substrat aus einer Siliziumkristallscheibe besteht, die getrennt durch eine Siliziumoxid-oder Siliziumnitridschicht mit einer Schicht (1) aus einem hochschmelzenden Metall oder einem hochschmelzenden Metallsilizid versehen ist.

7. Dreidimensionale 1-Transistorzellenanordnung nach einem der Ansprüche 1 bis 6, **dadurch gekennzeichnet,** daß die Kondensatorisolatorschicht (3, 23) aus einem Material mit hoher Dielektrizitätskonstante und hoher Durchbruchfeldstärke besteht.

8. Dreidimensionale 1-Transistorzellenanordnung nach einem der Ansprüche 1 bis 7, **dadurch gekennzeichnet,** daß die Kondensatorisolatorschicht (3, 23) aus einem Oxid oder Nitrid des Substratmetalles gebildet ist.

9. Dreidimensionale 1-Transistorzellenanordnung nach einem der Ansprüche 1 bis 8, **dadurch gekennzeichnet,** daß die mit den Source/Drain-Zonen verbundene Elektrode (4, 24) des Kondensators aus Metall, Metallsilizid oder hochdotiertem Silizium besteht.

10. Dreidimensionale 1-Transistorzellenanordnung nach einem der Ansprüche 1 bis 8, **dadurch gekennzeichnet,** daß die elektrisch leitenden Bereiche (7) in der, vorzugsweise aus $SiO_2$ bestehenden Zwischenisolationsschicht (5) durch Abscheidung von Metallen, Metallsiliziden oder dotiertem Polysilizium erzeugt sind.

11. Verfahren zum Herstellen einer dreidimensionalen 1-Transistorzellenanordnung nach einem der Ansprüche 1 bis 10, **gekennzeichnet durch** den Ablauf der folgenden Verfahrensschritte:

a) Einbringen von Gräben (2) entsprechender Fläche des Speicherkondensators in ein Metallsubstrat (1) oder eine auf ein Substrat aufgebrachte metallisch-leitende Schicht (1),

b) Erzeugen der Isolationsschicht (3) für den Kondensator durch ganzflächige Oxidation der Oberfläche oder durch Abscheidung einer zusätzlichen Isolatorschicht,

c) ganzflächige Abscheidung einer leitenden Schicht (4) bis zur Grabenauffüllung (2),

d) ganzflächige Abscheidung einer als Zwischenisolation dienenden Schicht (5) aus dielektrischem Material,

e) Einbringen von Kontaktlöchern (6) in die Zwischenisolationsschicht (5) bis in den Bereich der aufgefüllten Grabenkondensatorschicht (4),

f) Auffüllen der Kontaktlöcher (6) mit elektrisch leitendem Material (7),

g) ganzflächige Abscheidung einer, gegebenenfalls je nach Kanaltyp bei der Abscheidung oder danach, dotierten polykristallinen oder amorphen Siliziumschicht (8) und Überführung dieser Schicht (8) in den einkristallinen Zustand,

h) Herstellen von, voneinander isolierten Feldeffekt-Transistoren (8, 9, 10, 11) in bekannter Weise, wobei

i) durch Einbringen von dotierenden Elementen nach der Herstellung der Source-Drain-Gebiete eine leitende Verbindung (13) zwischen dem Source-Drain-Gebiet (11) des Feldeffekttransistors, das nicht mit der späteren Bitleitung (12, 15) kontaktiert wird, und dem Kondensator (1, 3, 4, 7) hergestellt wird (Figur 9).

12. Verfahren nach Anspruch 11, **dadurch gekennzeichnet,** daß beim Verfahrensschritt h) nach dem Herstellen der Bereiche (9), die die Feldeffekt-Transistoren voneinander isolieren, Dotierstoffe vom entgegengesetzten Leitungstyp wie die einkristalline Siliziumschicht (8) in die Bereiche (26) dieser Schicht (8) eingebracht werden, die die oberhalb des aus der leitenden Verbindung (7) gebildeten Kontaktes und unterhalb der später erzeugten Wortleitung (W) der benachbarten Speicherzelle liegen (Figur 15).

13. Verfahren zum Herstellen einer dreidimensionalen 1-Transistorzellenanordnung nach Anspruch 11, **dadurch gekennzeichnet,** daß anstelle der Verfahrensschritte a) bis e) folgende Verfahrensschritte durchgeführt werden:

a₁) Erzeugen der Isolationsschicht (23) für den Speicherkondensator (1, 23, 24) durch ganzflächige Oxidation eines Metallsubstrates (1) oder einer auf ein Substrat aufgebrachten metallisch leitenden Schicht (1),

b₁) ganzflächige Abscheidung einer leitenden Schicht (24),

c₁) Strukturierung dieser Schicht (24) entsprechend der Fläche des Speicherkondensators,

d₁) ganzflächige Abscheidung einer als Zwischenisolation dienenden, die Oberfläche planarisierenden Schicht (25),

e₁) Einbringen von Kontaktlöchern in diese Schicht (25) bis in den Bereich der strukturierten metallisch leitenden Schicht (24) (Figur 14).

14. Verfahren nach Anspruch 13, **dadurch gekennzeichnet,** daß bei der ganzflächigen Abscheidung nach Verfahrensschritt d₁) eine Bor-Phosphor-Glasschicht (25) aufgebracht wird (Figur 14).

15. Verfahren nach einem der Ansprüche 11 bis 14, **dadurch gekennzeichnet,** daß im Anschluß an die Verfahrensschritte a) bis e) bzw. a₁) bis e₁) und f) und g) zur Herstellung der Feldeffekt-Fransistoren folgende Schritte durchgeführt werden:

h) Erzeugen von Feldoxidbereichen (9) in der einkristallinen Siliziumschicht (8) zur Trennung der aktiven Transistorbereiche, beispielsweise durch selektive Durchoxidation,

i) Durchführung der Gateoxidation,

j) Abscheidung und Strukturierung der Gate-Elektroden (10),

k) Durchführung einer n⁻-bzw. p⁻-Ionenimplantation zur Erzeugung von schwach dotierten Drain-Zonen (11),

l) Durchführung einer konformen $SiO_2$-Abscheidung und Rückätzung zur Erzeugung von Flankenoxiden an den Gate-Elektroden (10),

m) Erzeugung der Source/Drain-Zonen, vorzugsweise durch Implantation von n-bzw. p-dotierenden Ionen in mindestens zwei Schritten, wobei im ersten Schritt eine flache Ionenimplantation (12) und im zweiten Schritt nach Maskierung der für den späteren Bitleitungsanschluß vorgesehenen Bereich (12) eine oder mehrere tiefe Implantationen zur Herstellung der leitenden Verbindung (13) zwischen dem nichtmaskierten Gebiet und dem Kondensator durchgeführt werden,

n) ganzflächige Abscheidung von $SiO_2$ als Zwischenoxid (14) und

o) Erzeugen von Kontaktlöchern zu den für die Bitleitung vorgesehenen Bereiche (12) und Durchführung der Metallisierung (15).

16. Verfahren nach einem der Ansprüche 11 bis 15, **dadurch gekennzeichnet,** daß alle Gräben (2, 6) und Kontaktlöcher durch isotrope Trockenätzprozesse, vorzugsweise durch reaktives Ionenätzen, erzeugt werden.

## FIG 1

## FIG 2

## FIG 3

## FIG 4

## FIG 5

## FIG 6

## FIG 7

## FIG 8

## FIG 9

## FIG 10

FIG 11

FIG 12

FIG 13

FIG 14

## FIG 15

## FIG 16

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | EP-A-0 168 528 (SIEMENS AG)<br><br>* Zusammenfassung; Figuren 1,3 * | 1-3,7, 10,11, 15 | H 01 L 27/10<br>H 01 L 21/20 //<br>G 11 C 11/34 |
| A | EP-A-0 167 764 (I.B.M.)<br><br>* Seite 10, Zeile 32 - Seite 13, Zeile 2; Figur 1 * | 1,2,7, 10 | |
| A | PATENT ABSTRACTS OF JAPAN, Band 8, Nr. 256 (E-280)[1693], 22. November 1984; & JP-A-59 129461 (FUJITSU K.K.) 25.07.1984<br>* Zusammenfassung; Figuren * | 1,3,7, 10,11, 15 | |
| A | PATENT ABSTRACTS OF JAPAN, Band 9, Nr. 39 (E-297)[1762], 19. Februar 1985; & JP-A-59 181661 (FUJITSU K.K.) 16.10.1984<br>* Zusammenfassung; Figuren * | 1-3,7 | RECHERCHIERTE SACHGEBIETE (Int. Cl.4)<br><br>H 01 L<br>H 01 G |
| A | PATENT ABSTRACTS OF JAPAN, Band 9, Nr. 266 (E-352)[1989], 23. Oktober 1985, & JP-A-60 111456 (TOSHIBA K.K.) 17.06.1985<br>* Zusammenfassung; Figuren * | 1,3,7 | |

-/-

Der vorliegende Recherchenbericht wurde für alle Patentansprüche erstellt.

| Recherchenort | Abschlußdatum der Recherche | Prüfer |
|---|---|---|
| DEN HAAG | 21-04-1987 | BAILLET B.J.R. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82

## EINSCHLÄGIGE DOKUMENTE

Seite 2

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | IEEE TRANSACTIONS ON ELECTRON DEVICES, Band ED-31, Nr. 6, Juni 1984, Seiten 746-753, IEEE, New York, US; H. SUNAMI et al.: "A corrugated capacitor cell (CCC)" * Seiten 747-748, Absatz IIIA; Figuren 3,5 * | 1,2,7, 11 | |
| | --- | | |
| A | EP-A-0 027 885 (IBM CORPORATION) * Seite 5, Zeile 11 - Seite 6, Zeile 30; Figuren 2,3 * | 1,3-8 | |
| | --- | | |
| A | PATENT ABSTRACTS OF JAPAN, Band 10, Nr. 32 (E-379)[2089], 7. Februar 1986; & JP-A-60 189218 (MATSUSHITA DENKI SANGYO K.K.) 26.09.1985 * Zusammenfassung * | 1 | |
| | ----- | | RECHERCHIERTE SACHGEBIETE (Int. Cl.4) |

Der vorliegende Recherchenbericht wurde für alle Patentansprüche erstellt.

| Recherchenort | Abschlußdatum der Recherche | Prüfer |
|---|---|---|
| DEN HAAG | 21-04-1987 | BAILLET B.J.R. |